# EUROPEAN PATENT SPECIFICATION

(11) **EP 2 469 583 B1**
(45) Date of publication and mention of the grant of the patent: **22.05.2019**
(21) Application number: 11189846.6
(22) Date of filing: 18.11.2011
(51) Int. Cl.: H01L 29/778, H01L 21/335, H01L 29/20

(54) **Stress modulated group III-V semiconductor device and related method**
Stress-modulierte Gruppe III-V-Halbleitervorrichtung und zugehöriges Verfahren
Dispositif semi-conducteur du groupe III-V modulé par le stress et procédé associé

(30) Priority: 21.12.2010 US 928946
(43) Date of publication of application: 27.06.2012
(73) Proprietor: Infineon Technologies Americas Corp., El Segundo, CA 90245 (US)
(72) Inventor: Chandolu, Anilkumar, Meridian, ID Idaho 83642 (US); Birkhahn, Ronald H., Dublin, CA California 94568 (US); Larsen, Troy, Oakdale, MN Minnesota 55128 (US); Hughes, Brett, Hugo, MN Minnesota 55038 (US); Hoff, Steve, Elk River, MN Minnesota 55330 (US); Nelson, Scott, River Falls, WI Wisconsin 54022 (US); Brown, Robert, Minneapolis, MN Minnesota 55411 (US); Sass, Leanne, Prior Lake, MN Minnesota 55372 (US)
(74) Representative: JENSEN & SON

(56) References cited:
- EP-A1- 1 978 550
- WO-A2-2006/124387
- US-A1- 2005 133 816
- US-A1- 2006 286 782
- US-A1- 2007 045 639
- US-A1- 2010 243 989

## Description

### BACKGROUND OF THE INVENTION

### DEFINITION

In the present application, "group III-V semiconductor" refers to a compound semiconductor that includes at least one group III element and at least one group V element, such as, but not limited to, gallium nitride (GaN), gallium arsenide (GaAs), indium aluminum gallium nitride (InAlGaN), indium gallium nitride (InGaN) and the like. Analogously, "III-nitride semiconductor" refers to a compound semiconductor that includes nitrogen and at least one group III element, such as, but not limited to, GaN, AlGaN, InN, AlN, InGaN, InAlGaN and the like.

### 1. FIELD OF THE INVENTION

The present invention is generally in the field of semiconductor devices and their fabrication. More specifically, the present invention is in the field of group III-V power semiconductor devices and their fabrication.

### 2. BACKGROUND ART

US 2010/243989 A1 discloses a semiconductor device includes a substrate, a superlattice buffer layer that is formed on the substrate and is composed of first AlₓGa₁₋ₓN layers and second AlₓGa₁₋ₓN layers having an Al composition greater than that of the first AlₓGa₁₋ₓN layers, the first and second AlₓGa₁₋ₓN layers being alternately stacked one by one, both the Al compositions of the first and second AlₓGa₁₋ₓN layers being greater than 0.3, and a difference in Al composition between the first and second AlₓGa₁₋ₓN layers being greater than 0 and smaller than 0.6.

Group III-V semiconductor devices include group III-V materials, for example, III-nitride materials, which are typically grown over a substrate, such as, a sapphire, silicon carbide, or silicon substrate, and may provide an active area for fabrication of the semiconductor device. Silicon substrates have several advantages over other substrate materials, including their high quality, low cost, and large wafer size. However, using a silicon substrate as a support substrate for a group III-V semiconductor device can introduce various problems. For example, due to lattice mismatch and differences in thermal expansion characteristics between III-nitride materials and silicon, thick III-nitride layers can produce substantial deformation of the silicon wafer, which can in turn cause the III-nitride layers to warp and crack. As such, group III-V semiconductor devices grown using a silicon substrate typically include various layers between the active region of the device and the substrate to compensate for problems introduced when using a silicon, or other non-native, substrate. The layers can include a buffer layer formed on compositionally graded transition layers. The thickness and composition of the layers must typically be carefully controlled to prevent the undesirable warping and cracking.

However, in a group III-V semiconductor device, the thickness of its buffer layer contributes to its voltage breakdown resistance. In high power applications, it is desirable for the group III-V semiconductor device to have a high breakdown voltage, which can be achieved, in principle, using a thick buffer layer. Unfortunately, concerns about substrate deformation limit the buffer layer thickness in most conventional group III-V semiconductor devices to slightly greater than approximately 1.0 um, thereby limiting the breakdown voltage of the semiconductor device.

Thus, there is a need to overcome the drawbacks and deficiencies in the art by a solution enabling growth of thick group III-V semiconductor layers while concurrently limiting substrate deformation.

### SUMMARY OF THE INVENTION

A group III-V semiconductor device is provided that comprises a compositionally graded body disposed over the substrate and below a buffer layer supporting an active area of said group III-V semiconductor device. The compositionally graded body includes a first region applying compressive stress to said substrate, wherein said first region includes a first stress layer and a second stress layer formed on said first stress layer, a first aluminium content of said first stress layer being greater than a second aluminium content of said second stress layer and a stress modulating region over said first region, said stress modulating region applying tensile stress to said substrate, wherein said stress modulating region includes a third stress layer formed on said second stress layer, a third aluminium content of said third stress layer being greater than that of said first and second aluminium content.

A method of fabricating a group III-V semiconductor device is provided. The method comprises providing a substrate for said group III-V semiconductor device, forming a first region of a compositionally graded body over said substrate to apply compressive stress to said substrate, wherein said first region includes a first stress layer and a second stress layer formed on said first stress layer, a first aluminium content of said first stress layer being greater than a second aluminium content of said second stress layer, forming a stress modulating region of said compositionally graded body over said first region, said stress modulating region applying tensile stress to said substrate, wherein said stress modulating region includes a third stress layer formed on said second stress layer, a third aluminium content of said third stress layer being greater than that of said first and second aluminium contents .

### BRIEF DESCRIPTION OF THE DRAWINGS

Figure 1 shows a cross-sectional view of a group III-V semiconductor structure including a compositionally graded body having a stress modulating region, in accordance with one embodiment of the present invention.
Figure 2 shows a flowchart presenting a method of fabricating a group III-V semiconductor device including a stress modulating compositionally graded body, in accordance with one embodiment of the present invention.
Figure 3A shows a cross-sectional view, which includes a portion of a wafer processed according to an embodiment of the invention, corresponding to an initial step in the flowchart in Figure 2.
Figure 3B shows a cross-sectional view, which includes a portion of a wafer processed according to an embodiment of the invention, corresponding to an intermediate step in the flowchart in Figure 2.
Figure 3C shows a cross-sectional view, which includes a portion of a wafer processed according to an embodiment of the invention, corresponding to an intermediate step in the flowchart in Figure 2.
Figure 3D shows a cross-sectional view, which includes a portion of a wafer processed according to an embodiment of the invention, corresponding to a final step in the flowchart in Figure 2.

### DETAILED DESCRIPTION OF THE INVENTION

The present invention is directed to a stress modulated group III-V semiconductor device and related method. More particularly, the present invention is directed to stress modulation in various embodiments of a novel semiconductor device including a compositionally graded body. The following description contains specific information pertaining to the implementation of the present invention. One skilled in the art will recognize that the present invention may be implemented in a manner different from that specifically discussed in the present application. Moreover, some of the specific details of the invention are not discussed in order not to obscure the invention. The drawings in the present application and their accompanying detailed description are directed to merely exemplary embodiments of the invention. To maintain brevity, other embodiments of the present invention are not specifically described in the present application and are not specifically illustrated by the present drawings.

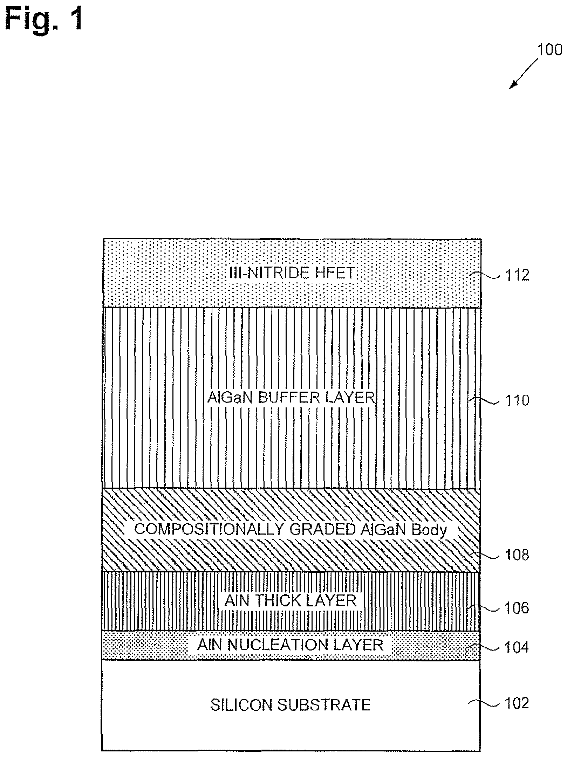

Figure 1 shows an exemplary semiconductor device structure including a compositionally graded body having a stress modulating region, in accordance with one embodiment of the present invention. Structure 100 includes substrate 102, nucleation layer 104, thick layer 106, compositionally graded body 108, buffer layer 110, and an active area including a group III-V semicondcutor device in the form of III-nitride heterojunction field-effect transistor (HFET) 112.

As shown in Figure 1, nucleation layer 104 is formed over substrate 102, thick layer 106 is formed over nucleation layer 104, compositionally graded body 108 is formed over thick layer 106, buffer layer 110 is formed over compositionally graded body 108, and the active area including HFET 112 is formed over buffer layer 110. Nucleation layer 104, thick layer 106, compositionally graded body 108, buffer layer 110, and HFET 112 can each comprise epitaxial layers, grown, for example, using Molecular Beam Epitaxy (MBE). However, other suitable growth methods, such as Hydride Vapor Phase Epitaxy (HVPE), or Metal-Organic Chemical Vapor Deposition (MOCVD), for example, can be used.

In the embodiment shown in Figure 1, structure 100 comprises a group III-V semiconductor device. More particularly, structure 100 comprises a III-nitride HFET 112. As such, in some embodiments HFET 112 can comprise, for example, a high electron mobility transistor (HEMT). For example, HFET 112 can comprise a heterojunction formed by the interface of an aluminum gallium nitride (AlGaN) region and a gallium nitride (GaN) region (AlGaN/GaN heterojunction not shown in Figure 1).

Substrate 102 comprises a semiconductor substrate. Substrate 102 has lattice mismatch and differences in thermal expansion characteristics compared to the III-nitride semiconductor material forming HFET 112. In the embodiment shown in Figure 1, substrate 102 comprises a silicon substrate, for example, a <111> silicon substrate. However, in other embodiments, substrate 102 can comprise other suitable materials such as, for example, sapphire or silicon carbide, such that substrate 102 has lattice mismatch and differences in thermal expansion characteristics compared to the III-nitride or other group III-V semiconductor material of HFET 112. As such, structure 100 includes various layers to compensate for problems introduced when forming HFET 112 over substrate 102. For example, structure 100 includes nucleation layer 104, thick layer 106, compositionally graded body 108, and buffer layer 110.

As shown in Figure 1, nucleation layer 104 is formed on substrate 102 and allows for growth of a suitable thick layer 106. In structure 100, nucleation layer 104 and thick layer 106 are exemplary and support compositionally graded body 108. In the embodiment shown in Figure 1, nucleation layer 104 and thick layer 106 each comprise aluminum nitride (AlN). However, in other embodiments, other suitable materials and/or layers can be used as support for compositionally graded body 108.

Also shown in Figure 1, structure 100 includes compositionally graded body 108. Compositionally graded body 108 can allow for formation of a thick, high quality buffer layer 110 without cracking or even substantial warping. In structure 100, compositionally graded body 108 comprises multiple layers of graded composition. For example, compositionally graded body 108 can comprise layers of AlGaN having varying composition. By controlling the composition and thickness of those layers, compositionally graded body 108 can modulate the stresses applied to substrate 102 in order to minimize or reduce the total stress applied to substrate 102 due to formation of structure 100.

Conventional semiconductor devices typically include regions of decreasing aluminum content to transition the lattice mismatch from substrate 102 to buffer layer 110. The present inventors realize that the conventional approach tends to progressively increase the compressive stress applied to substrate 102 as the aluminum content of the transition layers is reduced. According to the present inventive concepts, however, compositionally graded body 108 includes at least one stress modulating region, which can reverse the net stress applied by that region to substrate 102 so as to apply tensile stress to substrate 102. Thus, compositionally graded body 108 can be configured to modulate the compressive and tensile stresses applied to substrate 102 to avoid the warping and cracking that can result from deformation of substrate 102 due to the accumulated compressive stress in the conventional approach.

Furthermore, compositionally graded body 108 can effectively transition the lattice mismatch between substrate 102 and buffer layer 110. For example, in the embodiment shown in Figure 1, compositionally graded body 108 can transition lattice mismatch between substrate 102 comprising silicon and buffer layer 110 comprising III-nitride semiconductor material, such that buffer layer 110 can be formed on compositionally graded body 108. By transitioning lattice mismatch between substrate 102 and buffer layer 110, compositionally graded body 108 can deter dislocations in buffer layer 110 and the active group III-V area in which HFET 112 is formed.

Figure 1 represents buffer layer 110 supporting HFET 112 as comprising AlGaN. While buffer layer 110 can comprise AlGaN, in other embodiments buffer layer 110 can comprise other group III-V semiconductor material, for example, GaN. In structure 100, buffer layer 110 can apply stress to substrate 102. For example, buffer layer 110 can apply additional compressive stress to substrate 102, which can vary with the thickness of buffer layer 110.

In conventional III-nitride semiconductor devices, for example, a continuous buffer layer thicker than approximately 1.3 um can cause a substrate to significantly deform, leading to the undesirable warping and crack described above. Thus, some conventional semiconductor devices include a thick substrate to withstand stress from a thick buffer layer. However, including a thick substrate can substantially increase material and fabrication cost. Other conventional strategies for enabling formation of a thick buffer layer can include a non-continuous buffer layer having layers of varying composition, which can deteriorate device performance, for example by reducing voltage breakdown resistance. However, in an embodiment of the present invention, structure 100 can include a thick buffer layer 110 of substantially continuous composition providing high voltage breakdown resistance, for example, an AlGaN buffer layer of substantially continuous composition, while avoiding the disadvantages associated with thick substrates and the potential for warping and cracking present in the conventional art.

As mentioned above, buffer layer 110 can be used to electrically isolate HFET 112 from substrate 102. For example, increasing the thickness of buffer layer 110 can increase the breakdown voltage of semiconductor device 110. In some embodiments of the present invention, buffer layer 110 can be formed to a thickness of approximately 3 um, or greater, thereby enabling a breakdown voltage for HFET 112 of, for example, 900-1000 volts. Thus, structure 100 can support a high breakdown voltage so as to be suitable for high power applications.

It will be appreciated that structure 100 represents an exemplary group III-V semiconductor device including a compositionally graded body, in accordance with one embodiment of the present invention. As such, other embodiments of the present invention can utilize varying materials and layers. For example, while structure 100 includes aluminum, gallium and nitrogen, other embodiments can also include indium, or other suitable constituents as described in the Definition section above.

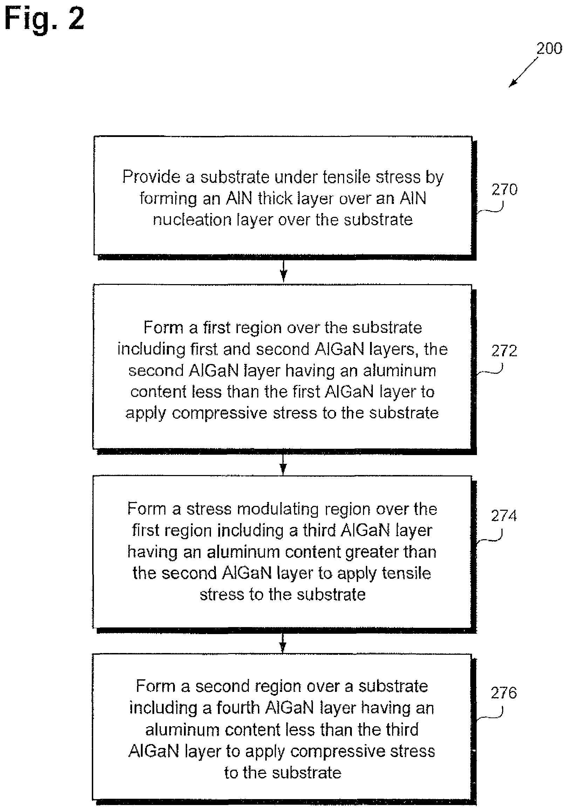

Referring now to Figure 2, Figure 2 shows a flow chart illustrating a method of fabricating a group III-V semiconductor device including a stress modulating compositionally graded body, according to an embodiment of the present invention. Certain details and features have been left out of flowchart 200 that are apparent to a person of ordinary skill in the art. For example, a step may consist of one or more substeps or may involve specialized equipment or materials, as known in the art. Steps 270 through 276 indicated in flowchart 200 are sufficient to describe an embodiment of the present invention; however, other embodiments of the invention may utilize steps different from those shown in flowchart 200.

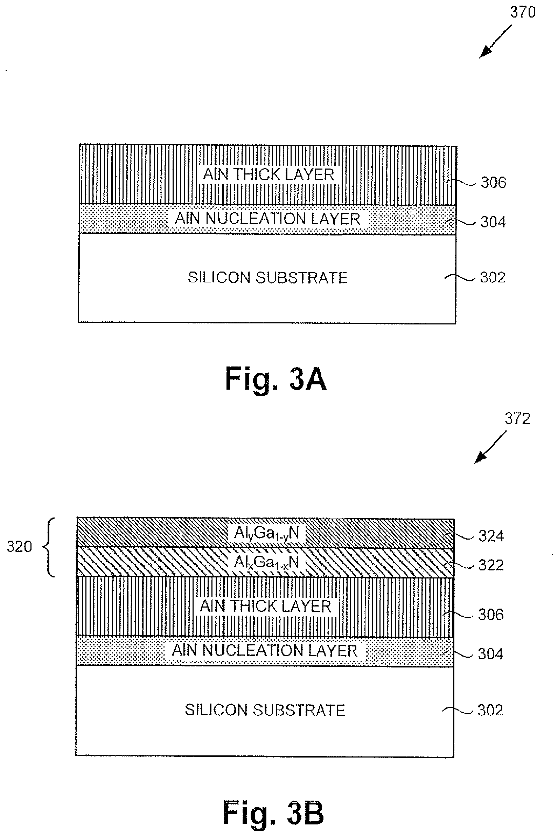

It is noted that the processing steps shown in flowchart 200 are performed on a processed wafer, which may also be referred to simply as a wafer or a semiconductor die or simply a die in the present application. Moreover, structures 370 through 376 in Figures 3A through 3D illustrate the result of performing steps 270 through 276 of flowchart 200, respectively. For example, structure 370 shows a semiconductor structure after processing step 270, structure 372 shows structure 370 after the processing of step 272, structure 374 shows structure 372 after the processing of step 274, and so forth.

Referring now to step 270 of Figure 2 and Figure 3A, step 270 of flowchart 200 comprises providing a substrate under tensile stress by forming an AlN thick layer over an AlN nucleation layer over the substrate. Structure 370 of Figure 3A shows a cross-sectional view of a structure including a substrate, after completion of step 270 of flowchart 200 in Figure 2. In structure 370, substrate 302 corresponds to substrate 102, nucleation layer 304 corresponds to nucleation layer 104, and thick layer 306 corresponds to thick layer 106 in Figure 1. In Figure 3A, substrate 302 is provided under tensile stress by forming nucleation layer 304 over substrate 302 and thick layer 306 over nucleation layer 304. Thick layer 306 can be formed, for example, by growing AlN in a high temperature process. It will be appreciated that the tensile stress is such that substrate 302 is provided substantially without cracking.

Referring now to step 272 in Figure 2 and structure 372 in Figure 3B, at step 272 of flowchart 200, stress region 320 is formed over substrate 302 to apply compressive stress to substrate 302. In structure 372, stress region 320 corresponds to a region of compositionally graded body 108 in Figure 1, which is at an early stage of formation in structure 372. As shown in Figure 3B, stress region 320 includes stress layers 322 and 324, which can correspond to respective compositionally graded layers in compositionally graded body 108. Thus, stress layers 322 and 324 can have varying compositions, for example, varying compositions of AlGaN.

As shown in Figure 3B, in structure 372, stress layer 322 comprises AlₓGa₁₋ₓN and stress layer 324 comprises Al_{y}Ga_{1-y}N, where each of subscripts "x" and "y" represents a different aluminum content in each respective layer. In structure 372, subscript "x" can be less than 1 and greater than 0. Also in structure 372, stress layer 324, formed on stress layer 322, has an aluminum content lower than stress layer 322. As such, in stress layer 324, subscript "y" has a value less than the value of subscript "x," such that stress region 320 includes layers of decreasing aluminum content. Thus, stress region 320 can apply compressive stress to substrate 302.

In the embodiment of Figure 3B, substrate 302 is provided to step 272 under tensile stress. By applying compressive stress to substrate 302, stress region 320 can reduce net tensile stress to substrate 302. Furthermore, in some embodiments, stress layer 322 can apply compressive stress to substrate 302 to reduce net tensile stress to substrate 302 and stress layer 324 can apply sufficient additional compressive stress to provide substrate 302 under a net compressive stress upon completion of step 272. The result of step 272 of flowchart 200 is illustrated by structure 372 in Figure 3B.

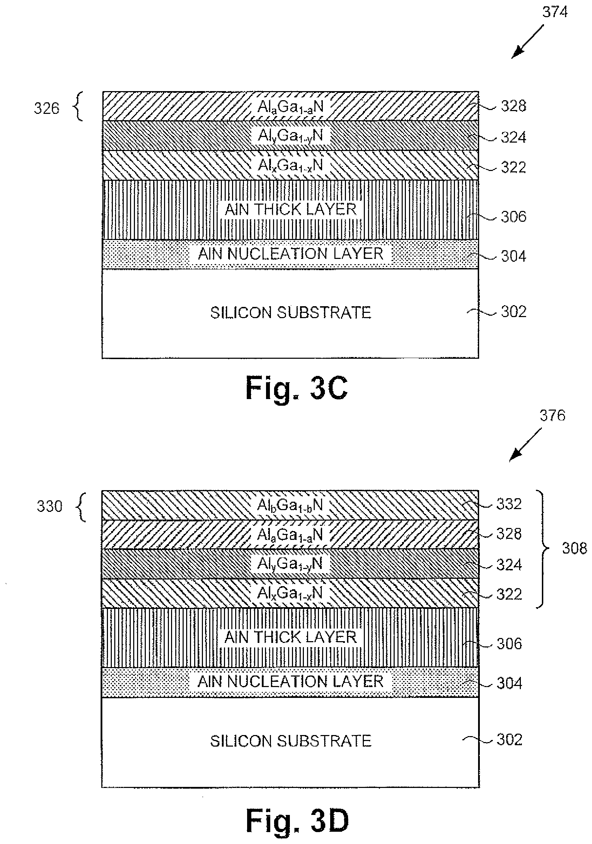

Referring now to step 274 in Figure 2 and structure 374 in Figure 3C, at step 274 of flowchart 200, stress modulating region 326 is formed over stress region 320 to apply tensile stress to substrate 302. In structure 374, stress modulating region 326 corresponds to a region of compositionally graded body 108 in Figure 1, which is at an intermediate stage of formation in structure 374. In the embodiment shown in Figure 3C, stress modulating region 326 comprises stress modulating layer 328, which is formed on stress layer 324 of stress region 320.

In structure 374, stress modulating layer 328 comprises AlGaN having composition AlₐGa₁₋ₐN where subscript "a" represents the aluminum content in stress modulating layer 328. Notably, stress modulating layer 328 has an aluminum content higher than stress layer 324, such that, stress modulating region 326 applies a tensile stress to substrate 302. As such, subscript "a" can range from a value greater than the value of subscript "y", to 1. Thus, stress modulating region 328 can apply tensile stress to substrate 302, such that, substrate 302 is provided under, for example, a net tensile stress upon completion of step 274. The value of subscript "a" exceeds the value of subscript "x" as well as that of subscript "y". The result of step 274 of flowchart 200 is illustrated by structure 374 in Figure 3C. Referring now to step 276 in Figure 2 and structure 376 in Figure 3D, at step 276 of flowchart 200, stress region 330 is formed over stress modulating region 326. In structure 372, stress region 330 corresponds to a region of compositionally graded body 308, which, in turn, corresponds to compositionally graded body 108 in Figure 1 . In the embodiment shown in Figure 3D , stress region 330 comprises stress layer 332 formed on stress modulating layer 328. In structure 376, stress layer 328 comprises AlGaN having composition AlbGai-bN where subscript "b" represents the aluminum content in stress layer 332. Furthermore, in structure 376, stress layer 332 has an aluminum content lower than stress modulating layer 328, such that, stress region 330 applies a compressive stress to substrate 302. As such, the value of subscript "b" is less than that of subscript "a." Thus, in some embodiments, stress region 330 can apply a compressive stress to substrate 302 to provide substrate 302 under a reduced net tensile stress upon completion of step 276. The result of step 276 of flowchart 200 is illustrated by structure 376 in Figure 3D.

Thus, the method illustrated in Figure 2 and Figures 3A through 3D provides for a compositionally graded body including a stress modulating region as part of a group III-V semiconductor device. Additional steps can be performed on structure 376 to fabricate structure 100 in Figure 1. For example, step 276 of flowchart 200 provides compositionally graded body 308, having a suitable lattice structure such that a buffer layer, for example buffer layer 110 in Figure 1 can be formed thereon without cracking or significant warping.

As discussed above, the buffer layer can apply compressive stress to the substrate, for example, substrate 302. In conventional semiconductor devices, a thick buffer layer can apply compressive stress to the substrate in addition to the accumulated compressive stress produced by the layers used to transition between the substrate and the buffer layer, resulting in significant warping and/or cracking. However, by including stress modulating region 326, compositionally graded body 308 can modulate the stresses applied to substrate 302 to reduce the net applied stress, thereby reducing the incidence of significant warping and/or cracking. More particularly, stress modulating region 326 can apply tensile stress to substrate 302 compensate for excessive compressive stress applied by a thick buffer layer.

Subsequently, structure 100 can be formed by fabricating HFET 112 on buffer layer 110 and cooling the wafer, which can apply additional tensile stress to substrate 302. Preferably, each layer in structure 100 is controlled to result in a substantially stress free substrate 302 after wafer cooling. For example, by adjusting the thickness and composition of the various semiconductor device layers, the stresses on substrate 302 can be balanced to limit the net stress applied to substrate 302.

It will be appreciated that the method illustrated in Figure 2 and Figures 3A through 3D is merely exemplary and is not intended to limit to the scope of the present invention. For example, while stress region 320 in Figure 3B comprises stress layer 322 and 324, the number and thickness of stress layers in stress region 320 can be varied to adjust the stress applied to substrate 302. For example, in one embodiment, stress region 320 can comprise a single stress layer. Similarly, the number and thickness of layers in stress modulating region 326 and stress region 330 can be varied. In one embodiment, stress region 330 can be omitted. In another, compositionally graded body 308 can comprise a plurality of stress modulating regions.

The following embodiments may also be advantageous in the context of the present invention:
A group III-V semiconductor device comprising:
a compositionally graded body disposed over a substrate and below a buffer layer supporting an active area of said group III-V semiconductor device;
said compositionally graded body including a first stress layer having a first aluminum content, a second stress layer having a second aluminum content less than said first aluminum content, and a stress modulating layer having a third aluminum content greater than said second aluminum content formed over said second stress layer.

Said compositionally graded body may further include another stress layer having an aluminum content less than said third aluminum content over said stress modulating layer.

Said third aluminum content may be greater than said first aluminum content.

Said first stress layer, said second stress layer, and said stress modulating layer may each comprise AlGaN.

Said active area may comprise a heterojunction field-effect transistor (HFET).

Thus, as discussed above, the present invention achieves a group III-V semiconductor device including a compositionally graded body having a least one stress modulating region. By including the stress modulating region, the compositionally graded body can modulate stress applied to a substrate to provide for a thick continuous buffer layer in the semiconductor device without significant warping and/or cracking. Thus, the semiconductor device can have enhanced breakdown voltage, which is particularly desirable in high power semiconductor devices.

## Claims

1. A group III-V semiconductor device (100) comprising:
a compositionally graded body (108) disposed over the substrate (302) and below a buffer layer (110) supporting an active area (112) of said group III-V semiconductor device (100);
said compositionally graded body (108) including
a first region (320) applying compressive stress to said substrate, wherein said first region (320) includes a first stress layer (322) and a second stress layer (324) formed on said first stress layer (322), a first aluminium content (x) of said first stress layer (322) being greater than a second aluminium content (y) of said second stress layer (324); and
a stress modulating region (326) over said first region, said stress modulating region applying tensile stress to said substrate (302), wherein said stress modulating region (326) includes a third stress layer (328) formed on said second stress layer (324), a third aluminium content (a) of said third stress layer (328) being greater than that of said first and second aluminium content (x, y).

2. The group III-V semiconductor device (100) of claim 1, wherein said compositionally graded body (108) further includes a second region (332) over said stress modulating region (326), said second region (332) applying compressive stress to said substrate (302).

3. The group III-V semiconductor device (100) of claim 1, wherein said substrate (302) comprises silicon.

4. The group III-V semiconductor device (100) of claim 1, wherein said first, second, and third stress layers (322, 324, 328) comprise AIGaN.

5. The group III-V semiconductor device (100) of claim 1, wherein said buffer layer (110) comprises a continuous layer of group III-V semiconductor material.

6. The group III-V semiconductor device (100) of claim 1, wherein said buffer layer (110) comprises GaN.

7. The group III-V semiconductor device (100) of claim 1, wherein a thickness of said buffer (110) layer is greater than approximately 1.3 µm.

8. The group III-V semiconductor device (100) of claim 1, wherein said active area (112) comprises a heterojunction field effect transistor (HFET).

9. A method of fabricating a group III-V semiconductor device (100), said method comprising:
providing a substrate (302) for said group III-V semiconductor device (100);
forming a first region (320) of a compositionally graded body (108) over said substrate (302) to apply compressive stress to said substrate (302), wherein said first region (320) includes a first stress layer (322) and a second stress layer (324) formed on said first stress layer (322), a first aluminium content (x) of said first stress layer (322) being greater than a second aluminium content (y) of said second stress layer (324);
forming a stress modulating region (326) of said compositionally graded body (108) over said first region (320), said stress modulating region (326) applying tensile stress to said substrate, wherein said stress modulating region (326) includes a third stress layer (328) formed on said second stress layer (324), a third aluminium content (a) of said third stress layer (328) being greater than that of said first and second aluminium contents (x, y).

10. The method of claim 9, further comprising forming a second region (332) of said compositionally graded body (108) over said stress modulating region (326), said second region (332) applying compressive stress to said substrate (302).

11. The method of claim 9, wherein forming said first region (320) comprises forming said first stress layer (322) over said substrate (302).

12. The method of claim 9, further comprising forming a continuous buffer layer over said compositionally graded body (110) and an active area (112) over said continuous buffer layer.

13. The method of claim 12, wherein a thickness of said continuous buffer layer is greater than approximately 1.3 µm.

## Patentansprüche

1. Gruppe-III-V-Halbleitervorrichtung (100), umfassend:
einen in seiner Zusammensetzung abgestuften Körper (108), der über dem Substrat (302) und unter einer Pufferschicht (110), die einen aktiven Bereich (112) der Gruppe-III-V-Halbleitervorrichtung (100) trägt, angeordnet ist;
wobei der in seiner Zusammensetzung abgestufte Körper (108) umfasst:
einen ersten Bereich (320), der Kompressionsspannung auf das Substrat ausübt, wobei der erste Bereich (320) eine erste Spannungsschicht (322) und eine zweite Spannungsschicht (324), die auf der ersten Spannungsschicht (322) gebildet ist, umfasst, wobei ein erster Aluminiumgehalt (x) der ersten Spannungsschicht (322) höher als ein zweiter Aluminiumgehalt (y) der zweiten Spannungsschicht (324) ist; und
einen spannungsmodulierenden Bereich (326) über dem ersten Bereich, wobei der spannungsmodulierende Bereich Zugspannung auf das Substrat (302) ausübt, wobei der spannungsmodulierende Bereich eine dritte Spannungsschicht (328) umfasst, die auf der zweiten Spannungsschicht (324) gebildet ist, wobei ein dritter Aluminiumgehalt (a) der dritten Spannungsschicht (328) höher als der erste und der zweite Aluminiumgehalt (x, y) ist.

2. Gruppe-III-V-Halbleitervorrichtung (100) gemäß Anspruch 1, wobei der in seiner Zusammensetzung abgestufte Körper (108) ferner einen zweiten Bereich (332) über dem spannungsmodulierenden Bereich (326) umfasst, wobei der zweite Bereich (322) Kompressionsspannung auf das Substrat (302) ausübt.

3. Gruppe-III-V-Halbleitervorrichtung (100) gemäß Anspruch 1, wobei das Substrat (302) Silicium umfasst.

4. Gruppe-III-V-Halbleitervorrichtung (100) gemäß Anspruch 1, wobei die erste, die zweite und die dritte Spannungsschicht (322, 324, 328) AlGaN umfassen.

5. Gruppe-III-V-Halbleitervorrichtung (100) gemäß Anspruch 1, wobei die Pufferschicht (110) eine kontinuierliche Schicht von Gruppe-III-V-Halbleitermaterial umfasst.

6. Gruppe-III-V-Halbleitervorrichtung (100) gemäß Anspruch 1, wobei die Pufferschicht (110) Gan umfasst.

7. Gruppe-III-V-Halbleitervorrichtung (100) gemäß Anspruch 1, wobei eine Dicke der Pufferschicht (110) größer als etwa 1,3 µm ist.

8. Gruppe-III-V-Halbleitervorrichtung (100) gemäß Anspruch 1, wobei der aktive Bereich (112) einen Heteroübergang-Feldeffekttransistor (HFET) umfasst.

9. Verfahren zur Herstellung einer Gruppe-III-V-Halbleitervorrichtung (100), wobei das Verfahren umfasst:
Bereitstellen eines Substrats (302) für die Gruppe-III-V-Halbleitervorrichtung (100);
Bilden eines ersten Bereichs (320) aus einem in seiner Zusammensetzung abgestuften Körper (108) über dem Substrat (302), um Kompressionsspannung auf das Substrat (302) auszuüben, wobei der erste Bereich (320) eine erste Spannungsschicht (322) und eine zweite Spannungsschicht (324), die auf der ersten Spannungsschicht (322) gebildet ist, umfasst, wobei ein erster Aluminiumgehalt (x) der ersten Spannungsschicht (322) höher als ein zweiter Aluminiumgehalt (y) der zweiten Spannungsschicht (324) ist;
Bilden eines spannungsmodulierenden Bereichs (326) des in seiner Zusammensetzung abgestuften Körpers (108) über dem ersten Bereich, wobei der spannungsmodulierende Bereich (326) Zugspannung auf das Substrat ausübt, wobei der spannungsmodulierende Bereich (326) eine dritte Spannungsschicht (328) umfasst, die auf der zweiten Spannungsschicht (324) gebildet ist, wobei ein dritter Aluminiumgehalt (a) der dritten Spannungsschicht (328) höher als der erste und der zweite Aluminiumgehalt (x, y) ist.

10. Verfahren gemäß Anspruch 9, ferner umfassend Bilden eines zweiten Bereichs (332) des in seiner Zusammensetzung abgestuften Körpers (108) über dem spannungsmodulierenden Bereich (326), wobei der zweite Bereich (332) Kompressionsspannung auf das Substrat (302) ausübt.

11. Verfahren gemäß Anspruch 9, wobei das Bilden des ersten Bereichs (320) Bilden der ersten Spannungsschicht (322) über dem Substrat (302) umfasst.

12. Verfahren gemäß Anspruch 9, ferner umfassend Bilden einer kontinuierlichen Pufferschicht über dem in seiner Zusammensetzung abgestuften Körper (108) und eines aktiven Bereichs (112) über der kontinuierlichen Pufferschicht.

13. Verfahren gemäß Anspruch 12, wobei eine Dicke der kontinuierlichen Pufferschicht größer als etwa 1,3 µm ist.

## Revendications

1. Dispositif (100) semi-conducteur du groupe III-V, comprenant :
un corps (108) gradué en composition, disposé sur le substrat (302) et sous une couche (110) tampon supportant une zone (112) active du dispositif (100) semi-conducteur du groupe III-V ;
le corps (108) gradué en composition comprenant
une première région (320) appliquant une contrainte de compression au substrat, la première région (320) comprenant une première couche (322) de contrainte et une deuxième couche (324) de contrainte formée sur la première couche (322) de contrainte, une première teneur (x) en aluminium de la première couche (322) de contrainte étant plus grande qu'une deuxième teneur (y) en aluminium de la deuxième couche (324) de contrainte et
sur la première région, une région (326) modulant la contrainte, la région modulant la contrainte appliquant une contrainte de traction au substrat (302), la région (326) modulant la contrainte comprenant une troisième couche (328) de contrainte formée sur la deuxième couche (324) de contrainte, une troisième teneur (a) en aluminium de la troisième couche (328) de contrainte étant plus grande que celles de la première et de la deuxième teneur (x, y) en aluminium.

2. Dispositif (100) semi-conducteur du groupe III-V suivant la revendication 1, dans lequel le corps (108) gradué en composition comprend, en outre, une deuxième région (332) sur la région (326) modulant la contrainte, la deuxième région (332) appliquant une contrainte de compression au substrat (302) .

3. Dispositif (100) semi-conducteur du groupe III-V suivant la revendication 1, dans lequel le substrat (302) comprend du silicium.

4. Dispositif (100) semi-conducteur du groupe III-V suivant la revendication 1, dans lequel les première, deuxième et troisième couches (322, 324, 328) de contrainte comprennent de l'AlGaN.

5. Dispositif (100) semi-conducteur du groupe III-V suivant la revendication 1, dans lequel la couche (110) tampon comprend une couche continue de matériau semi-conducteur du groupe III-V.

6. Dispositif (100) semi-conducteur du groupe III-V suivant la revendication 1, dans lequel la couche (110) tampon comprend du GaN.

7. Dispositif (100) semi-conducteur du groupe III-V suivant la revendication 1, dans lequel une épaisseur de la couche (110) tampon est plus grande qu'environ 1,3 µm.

8. Dispositif (100) semi-conducteur du groupe III-V suivant la revendication 1, dans lequel la zone (112) active comprend un transistor à effet de champ à hétérojonction (HFET).

9. Procédé de fabrication d'un dispositif (100) semi-conducteur du groupe II-V, le procédé comprenant :
on se procure un substrat (302) pour le dispositif (100) semi-conducteur du groupe III-V ;
on forme une première région (320) d'un corps (108) gradué en composition sur le substrat (302), pour appliquer une contrainte de compression au substrat (302), la première région (320) comprenant une première couche (322) de contrainte et une deuxième couche (324) de contrainte formée sur la première couche (322) de contrainte, une première teneur (x) en aluminium de la première couche (322) de contrainte étant plus grande qu'une deuxième teneur (y) en aluminium de la deuxième couche (324) de contrainte ;
on forme, sur la première région (320), une région (326) modulant la contrainte du corps (108) gradué en composition, la région (326) modulant la contrainte appliquant une contrainte de traction au substrat, la région (326) modulant la contrainte comprenant une troisième couche (328) de contrainte formée sur la deuxième couche (324) de contrainte, une troisième teneur (a) en aluminium de la troisième couche (328) de contrainte étant plus grande que celles de la première et de la deuxième teneur (x, y) en aluminium.

10. Procédé suivant la revendication 9, comprenant, en outre, former une deuxième région (332) du corps (108) gradué en composition sur la région (326) modulant la contrainte, la deuxième région (332) appliquant une contrainte de compression au substrat (302).

11. Procédé suivant la revendication 9, dans lequel former la première région (320) comprend former la première couche (322) de contrainte sur le substrat (302).

12. Procédé suivant la revendication 9, comprenant, en outre, former une couche tampon continue sur le corps (120) gradué en composition et une zone (112) active sur la couche tampon continue.

13. Procédé suivant la revendication 12, dans lequel une épaisseur de la couche tampon continue est plus grande qu'environ 1,3 µm.
